Europäisches Patentamt

European Patent Office

Office européen des brevets

(11) Publication number: **0 284 436 B1**

## EUROPEAN PATENT SPECIFICATION

(45) Date of publication of patent specification: **21.07.93**

(51) Int. Cl.5: **H01J 37/32**, H05H 1/46, C23F 4/00

(21) Application number: **88302720.3**

(22) Date of filing: **25.03.88**

(54) **Substrate-treating apparatus.**

(30) Priority: **27.03.87 JP 71369/87**
**27.03.87 JP 74773/87**
**27.03.87 JP 74776/87**

(43) Date of publication of application:
**28.09.88 Bulletin 88/39**

(45) Publication of the grant of the patent:
**21.07.93 Bulletin 93/29**

(84) Designated Contracting States:
**DE FR GB IT NL**

(56) References cited:
**EP-A- 0 279 895**
**DE-A- 3 521 318**
**US-A- 4 401 054**

**PATENT ABSTRACTS OF JAPAN, vol. 7, no. 236 (E-205)[1381], 20th October 1983;& JP-A-58 125 820**

(73) Proprietor: **CANON KABUSHIKI KAISHA**
**30-2, 3-chome, Shimomaruko, Ohta-ku**
**Tokyo(JP)**

(72) Inventor: **Ohmi, Kazuaki**
**1581-17, Tsurumaki**
**Hadano-shi Kanagawa-ken(JP)**
Inventor: **Den, Tohru**
**40-16, Funabashi 1-chome**
**Setagaya-ku Tokyo(JP)**
Inventor: **Tsuda, Hisanori**
**13-41, Morinosato 1-chome**
**Atsugi-shi Kanagawa-ken(JP)**
Inventor: **Sugata, Masao**
**68-5, Nishi Kawashima-cho Asahi-ku**
**Yokohama-shi Kanagawa-ken(JP)**
Inventor: **Yokono, Kohjiro**
**2-14-308, Namiki 2-chome Kanazawa-ku**
**Yokohama-shi Kanagawa-ken(JP)**

(74) Representative: **Beresford, Keith Denis Lewis et al**
**BERESFORD & Co. 2-5 Warwick Court High Holborn**
**London WC1R 5DJ (GB)**

## Description

The present invention relates to an apparatus for treating substrates, utilizing plasma.

Methods of carrying our film formation or etching, utilizing a gas reaction, are known, including utilizing heat energy as in heat CVD, utilizing light energy absorbed by a gas to cause a decomposition reaction as in optical CVD, decomposition of a gas by plasma as in plasma CVD or plasma etching and utilizing kinetic energy of ions as in high frequency sputtering or ion beam sputtering.

An apparatus disclosing the production of plasma by means of microwaves in the presence of a magnetic field is disclosed in older EP-A-279895 (US-A-4,939,424). The plasma serves to coat a substrate which is situated in a chamber having metal walls. The microwaves are repeatedly reflected at the metal walls, so that the chamber has numerous microwave modes. Permanent magnets placed in the vicinity of the substrate produce an electron-cylotron resonance which permits a locally controlled ignition of the plasma.

In many conventional methods, however, it has been impossible to effect film formation or etching only on an object or a desired area of an object and it has frequently occurred that the reaction takes place over a wide area of the whole reaction chamber, making it difficult to control the reaction.

For this reason, the conventional methods have involved the disadvantages such that;

1) a pattern cannot easily be formed on an object;

2) because of etching or sputtering occurring on the inner wall of a reaction chamber, the inner wall is damaged, or otherwise a liberated impurity from the inner wall of a reaction chamber contaminates the film formed on an object;

3) electric discharge energy or raw material gas can not be effectively utilized;

4) the inner wall of a reaction chamber is stained to bring about minute defects caused by dust or the like on the film formed on an object; etc.

Also known as a reaction apparatus using the electronic cyclotron resonance (hereinafter "ECR") of microwaves, or related techniques, are those including the following:

(1) The most general type of reaction apparatus, in which a magnetic field to cause ECR to take place is formed in the vicinity of a microwave-introducing section, and electric discharge is caused to take place there (Japanese Patent Publications Laid-open No. 155535/1981 and No. 125820/1983).

(2) An exceptional type of reaction apparatus, in which an electric field satisfying ECR conditions is applied to microwaves having been propagated in a coaxial mode, and electric discharge is caused to take place there (J. Non-Cry. Sol., 77 & 78, 83, '85).

(3) Related techniques, in which microwaves are propagated inside a vacuum vessel to provide an ECR field by means of a permanent magnet at a prescribed position, and electric discharge is caused to take place there to wash the inner surface of the vessel at that position (a journal "SHINKU (Vacuum)", Vol. 28, No. 5, 145, '85).

However, in the conventional technique (1) mentioned above, a field at which the ECR conditions are set up exists in the vicinity of the microwave-introducing section, therefore bringing about the following problems:

(a) When, for example, the film formation is carried out, film deposition may occur at the microwave-introducing section because of the plasma existing in the vicinity of the microwave-introducing section, to make unstable or difficult the introduction of microwaves.

(b) Because of the plasma existing in the vicinity of the microwave-introducing section, the temperature at the introducing section is raised to make unstable the introduction of microwaves or to tend to cause the problem such as damage of the introducing section.

(c) Because of plasma of high density, generated in the vicinity of the microwave-introducing section, the microwaves may be intercepted to make it impossible to obtain plasma with high density near substrates, resulting in retardation of treatment of substrates.

In the conventional technique (2) mentioned above, there have been also involved the problems, besides the above problems (a) and (b), that because of plasma of high density and high temperature existing on the surfaces of substrates, damage to substrates by plasma may be caused, or when it is desired to make substrates larger in area, the means for forming magnetic fields must be made greater in scale, resulting in high costs.

Also in the case of the conventional technique (3), there has been the problem of causing the damage by plasma, when it is applied in the treatment of substrates.

Accordingly, an object of the present invention is to provide a substrate-treating apparatus that can prevent reaction products from being deposited on the inner wall of a reaction chamber or on the microwave-introducing window thereof.

Another object of the present invention is to provide a substrate-treating apparatus that can prevent the inner wall of a reaction chamber from being damaged owing to etching or sputtering on the inner wall in the course of film formation on substrates, and also prevent the film quality from being deteriorated by impurities coming from the inner wall.

A further object of the present invention is to provide a substrate-treating apparatus that can make direct patterning on substrates without using any complicated processes such as resist coating.

A still further object of the present invention is to provide a substrate-treating apparatus that can stably introduce microwaves and can increase the speed of the treatment of a substrate.

The above objects can be achieved by the invention described below.

According to a first aspect of the present invention, there is provided an apparatus for treating a substrate, comprising a chamber for encasing the substrate and provided with a microwave introducing section, means for generating plasma within said chamber to treat the substrate in the vicinity of the substrate and in a spatial zone sufficiently small as compared with the size of the chamber and a mesh provided between a plasma formation zone and the substrate.

In a preferred embodiment, the plasma is formed by utilizing electronic cyclotron resonance of microwaves. Preferably, the means for generating plasma is a means for forming a magnetic field.

According to a second aspect of the present invention, there is provided an apparatus for treating a substrate, comprising a chamber for encasing the substrate and provided with a microwave introducing section, means for generating plasma within said chamber to treat the substrate by said plasma, said substrate being microwave transmissive and placed in the vicinity of the microwave introducing section, wherein said means for generating plasma is provided to generate plasma in the vicinity of the substrate in a spatial zone sufficiently small as compared with the size of the chamber and at the substrate surface side opposite to the microwave introducing surface.

The invention will now be described by way of example only, in which Figures 1 to 3 are views illustrating examples of locally controlled ignition of a plasma;

Figure 4 is a view illustrating a magnet used in the apparatus of figure 3;

Figures 5 and 6 are views showing embodiments of the present invention;

Figure 7 is a view showing another example of the present invention and

Figure 8 is a view descriptive of a method of generating plasma in a minute zone according to the present invention.

The present invention is chiefly characterized by generation of plasma in the vicinity of a substrate and in a spatial zone sufficiently small as compared with the size of the chamber capable of holding the substrate.

In the present substrate-treating apparatus the principle is that electronic cyclotron discharge takes place if, particularly in a space in which microwave electric power with a frequency of 2.45 GHz exists, there is a site at which a magnetic flux of 0,08 $Vs/m^2$ (875 gauss) is coincident with 2.45 GHz even in part.

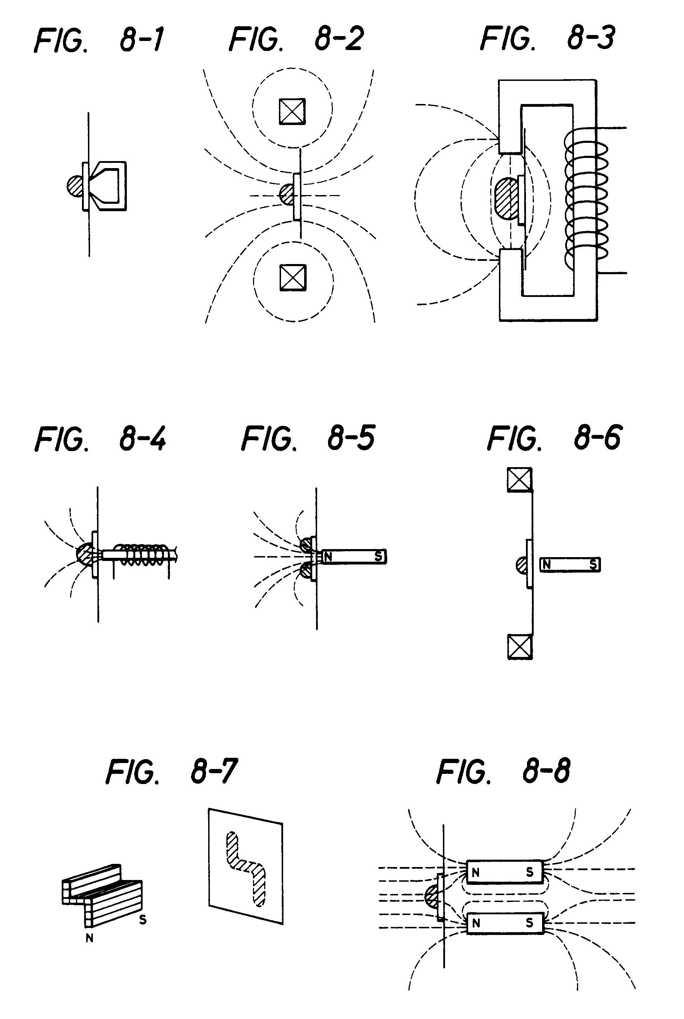

In the present invention, methods for generating plasma in minute spaces near a substrate include a method of forming a magnetic field that causes electronic cyclotron resonance to take place in a minute zone near the substrate, as shown, for example, by 1 to 8 in Fig. 8.

In Fig. 8, the method 1 can afford to concentrate a strong magnetic field at a small zone, and the method 2 makes it possible to form a large magnetic field gradient in the direction along the axis of a coil so that the plasma zone can be limited to the vicinity of a substrate. The method 3 enables the formation of a strong local magnetic field with less electric current, and the method 4 requires a larger electric current than the method 3 but is advantageous to take a large magnetic field gradient so that the plasma can be readily limited to a smaller zone. The method 5 can form the ECR conditions by use of a magnet. The method 6 comprises the combination of 2 and 5 and forms a magnetic field of less than 0,08 $Vsm^{-2}$ (875 gauss) by means of a coil to further strengthen the magnetic field by the use of a magnet. In this instance, the magnetic force of a permanent magnet may be small. The method 7 can afford to form a plasma pattern in the vicinity of a substrate by using a permanent magnet, and the method 8 facilitates limiting plasma to a small spatial zone with ease, and yet makes it possible to extend plasma to a site distant a little from a substrate.

The methods 1 to 8 in Fig. 8 are each selectively used depending on purposes and uses, but in any case the pressure must be lowered in order to make the plasma generation not to occur in the zone not satisfying the ECR conditions. The lower the pressure is, the more the plasma zone becomes coincident with the magnetic field zone of 0,08 $Vsm^{-2}$ (875 gauss).

An excessively high pressure shortens the mean free path, with the result that no ECR is substantially caused to take place. Suitable pressure is in the range of from 1,33 to 0,001 Pa ($10^{-2}$ to $10^{-5}$ Torr), preferably of the order of 0,01 Pa ($10^{-4}$ Torr).

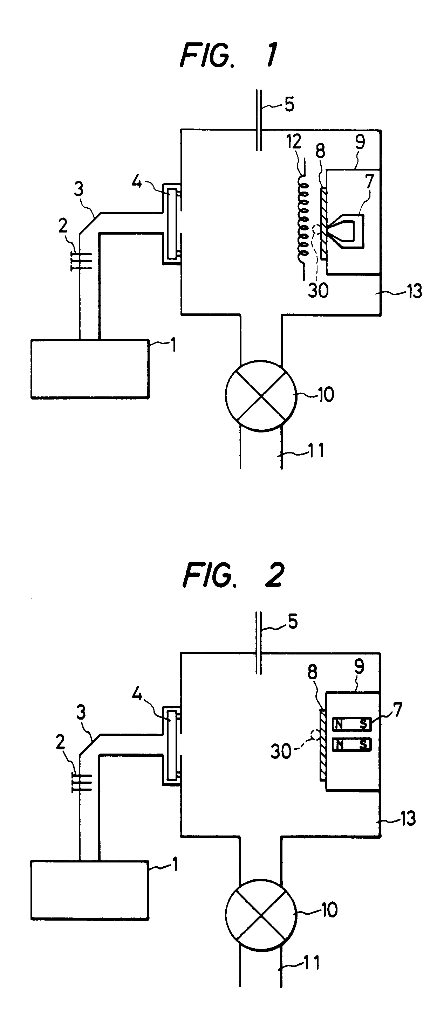

Fig. 1 illustrates locally controlled ignition of a plasma. In the figure, the numeral 1 denotes a microwave oscillator of 2.45 GHz; 2, a tuner; 3, a microwave waveguide; 4, a microwave-transmitting window made of quartz glass; and 5, a raw material gas introducing pipe, which is connected to a gas cylinder. The numeral 7 denotes a magnet for forming a local magnetic field. The numeral 8 denotes a glass substrate; 9, a substrate holder; 10, a main valve; and 11, an exhaust duct, which is connected to an exhaust pump. The numeral 12 denotes a filament for effecting the radiation heating of the substrate.

Here will be described an instance in which a spot of an amorphous Si (a-Si) film is formed on the surface of the quartz glass substrate by use of this apparatus.

First, using an exhaust system connected to the exhaust duct 11, the inside of a vacuum chamber 13 was exhausted to $133 \times 10^{-7}$ Pa ($10^{-7}$ Torr) or less, and thereafter the filament 12 was energized and brought to red heat to heat the surface of the substrate 8 up to 250 °C. Next, $Si_2H_6$ diluted to 10% with $H_2$ was flowed from the gas-introducing pipe 5 to the inside of the vacuum chamber 13 at the rate of 100 SCCM in total flow rate. The pressure in the vacuum chamber 13 at this time was $7,3 \times 0,13$ Pa ($7.3 \times 10^{-3}$ Torr). The permanent magnet 7 is of the type that a magnetic field of about $10^{-1}$ $Vsm^{-2}$ (1,000 gauss) can be formed at the top portion, and set at the position nearest to the substrate 8 placed inside the substrate holder 9.

Next, the microwave oscillator 1 was turned on to send microwaves into the inside of the vacuum chamber 13 through the waveguide 3 via the quartz window 4, and the tuner 2 was adjusted, so that a plasma was generated at a small zone 30 defined on the surface of the substrate 8 and in the area adjacent to the magnet 7. The power to apply the microwaves was 300 W. Pattern formation was continued for about 1 hour keeping this state, and thereafter the microwave oscillation was stopped, gas supply was stopped, and vacuum was eliminated to take out the substrate 8. On the surface of the substrate 8, there was formed a spot-shaped a-Si film of about 1 μm in film thickness. Measurement by infrared spectrum revealed that absorption was seen around 2,000 $cm^{-1}$, but little absorption was seen around 2,090 $cm^{-1}$. Analysis according to IMMA revealed that there was observed no inclusion of impurity metals into the film.

Next, substantially the same apparatus as in Fig. 1 was so modified that the substrate holder may be reciprocated in parallel to the substrate together with the substrate. Here, the magnet 7 was kept fixed in the vacuum chamber 13. Using the apparatus like this, the film formation was carried out in substantially the same manner as in the above. The substrate was reciprocated during the film formation. The substrate was taken out after the film formation to find that a stripe-shaped a-Si film extending in the direction of the movement of the substrate was formed on the substrate, and this stripe was much larger than the zone in which the plasma had spread.

Etching was further carried out using substantially the same apparatus as in Fig. 1. The gas used was $CF_4$ containing 10% of $O_2$, and the inside of the vacuum chamber was at a pressure of $1.5 \times 1,33$ Pa ($1.5 \times 10^{-2}$ Torr). Mounted on the substrate holder was an Al substrate on which previously a-Si was formed with a uniform thickness of 1.5 μm by RF glow discharge of $SiH_4$, and electric discharge was effected under microwave application power of 150 W. After 2 hours, the flow of gas was stopped, microwave generation was also stopped to terminate the electric discharge, and the substrate was taken out from the vacuum chamber to find that only the vicinity of the magnet, where the plasma had been generated, was etched and an area in which a-Si was removed and the Al ground metal was exposed was formed in a spot shape.

Fig. 2 illustrates another example of locally controlled ignition of a plasma. The respective numerals are the same as in Fig. 1 except for 7. The numeral 7 denotes a columnar permanent magnet made of samarium-cobalt, and 8 pieces thereof are set on the periphery in the form of a doughnut. The magnetic field at the center of the substrate 8 is about $9 \times 10^{-2}$ $Vsm^{-2}$ (900 gauss).

The film formation is carried out according to the same procedures as in the above for forming a spot of an amorphous Si film on the surface of the substrate 8 by using this apparatus. $SiH_4$ gas diluted to 10% with $H_2$ is flowed at a flow rate of 10 SCCM, and the main valve 10 is adjusted to keep the pressure inside the apparatus to about 0,013 Pa ($10^{-4}$ Torr). Keeping this state, the microwaves are introduced, so that the plasma is generated at a small zone 30 adjacent to the substrate. The power of the microwave application is 450 W. A spot-shaped a-Si film of about $5 \times 10^{-5}$ cm (5,000 Å) in film thickness is formed on the substrate 8 according to the above process. At this time, no plasma was generated in the vicinity of the microwave-introducing window 4, and a stable electric discharge is able to be maintained without deposition of any film on the surface of the window 4.

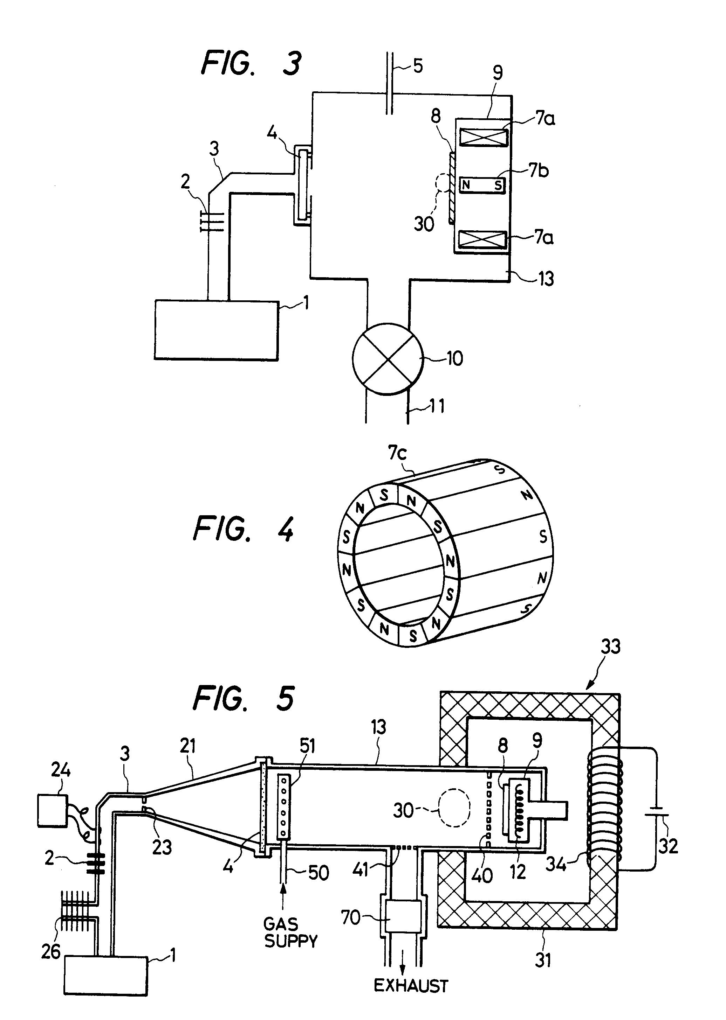

Fig. 3 illustrates still another example of locally controlled ignition of a plasma. The respective numerals are the same as in Fig. 1 except for 7a and 7b. The numeral 7a denotes an electromagnetic coil placed for the purpose of applying an magnetic field to the whole substrate, and 7b denotes a permanent magnet made of samarium-cobalt. A spot-shaped zone of $8,75 \times 10^{-2}$ $Vsm^{-2}$ (875 gauss) is formed in the vicinity of the substrate surface by controlling the relative position between the coil 7a, magnet 7b and substrate 8, and the electric current flowing in the coil 7a.

The film formation is carried out according to the same procedures as in the above when a spot of an amorphous Si film is formed on the surface of the substrate 8 by using this apparatus. SiH$_4$ gas diluted to 10% with H$_2$ is flowed at a flow rate of 10 SCCM, and the main valve 10 is adjusted to keep the pressure inside the apparatus to about 0,013 Pa ($10^{-4}$ Torr). Keeping this state, microwaves are introduced, so that the plasma is generated at a small zone 30 adjacent to the substrate. The power of the microwave application is 400 W. A spot-shaped a-Si film of about 5 x $10^{-5}$ cm (5,000 Å) in film thickness can be readily formed on the substrate 8 according to the above process. At this time, no plasma was generated in the vicinity of the microwave-introducing window 4, and a stable electric discharge was able to be maintained without any stains on the surface of the window 4.

Formation of a-Si pattern on the substrate is also carried out using the same apparatus as in Fig. 3 except for the magnet 7b. In place of the magnet 7b in Fig. 3, blocks of permanent magnets made of samarium-cobalt are joined together to make up a cylindrical magnet 7c as illustrated in Fig. 4. The cylinder is so designed as to have a diameter smaller than the size of the substrate 8 and to have its positional relationship as shown in Fig. 2.

Using such a magnet 7, the electric current flowing in the coil 7a is adjusted to form a spot having a magnetic field of about 8,75 x $10^{-2}$ Vsm$^{-2}$ (875 gauss) in the vicinity of the substrate and along the periphery of the cylindrical magnet 7c.

Next, plasma of SiH$_4$ diluted to 10% with H$_2$ is formed according to the same procedures and under the same conditions as the above. Thus, spots of small plasma are generated in a row in a cylindrical form in the vicinity of the substrate. Film formation is carried out keeping this state, so that a-Si spots of about 5 x $10^{-5}$ cm (5,000 Å) in film thickness each can be formed in one time with circular arrangement on the surface of the substrate.

Fig. 5 is a view illustrating an apparatus according to this invention provided with a mesh 40 for the purpose of decreasing the damage by plasma to the substrate.

The mesh 40 may be any of those which can control the attenuation of microwaves and the incident energy or incident density of charged particles (ions or electrons) projected into a substrate 8, and may be made of, for example, metals such as stainless steel, aluminum and molybdenum, those comprising a coating of any of these metals, or silicone, plastics or glass on which the absorption of microwaves may take place. Particularly preferred is a mesh 40 made of metals as any potential can be applied thereto to control the charged particles.

To one side of a chamber 13, is connected a horn antenna which is a kind of microwave antenna through a microwave-introducing section 4. It is preferred to provide this microwave antenna in order to propagate microwaves with good efficiency to a plasma zone 30 in the inner part of the chamber 13. As the microwave antenna, various antennas can be used besides the horn antenna 21, as exemplified by a slot antenna, a helix launcher, a Lisitano coil, etc.

A microwave oscillator 1 is connected to the microwave antenna 21 through a waveguide 3.

A constriction 23 is provided between the waveguide 3 and the microwave antenna 21, and a power monitor 24, a three-stub tuner 2 and an isolator 26 are provided to the waveguide 3.

In front of the microwave-introducing section 4 in the chamber 13, a ring gas ejector 51 connected to a gas-introducing pipe 50 is located so that a gas necessary for the reaction can be supplied. In this manner, gas is supplied from the vicinity of the microwave-introducing section 4 and is flowed therefrom to the plasma zone 30 side, whereby the film deposition on the microwave-introducing section is suppressed.

In the middle portion of the chamber 13, an exhaust pump 70 is connected through a mesh 41 so that the pressure in the chamber can be controlled and the surplus gas or the gas produced by reaction can be exhausted. The mesh 41 is provided to intercept the microwaves.

At the inner section of the chamber 13, a mesh 40 is provided, and kept at a section further inner thereto is a substrate 8 supported by a substrate holder 9. The substrate holder 9 is so designed to have a heater 12 for heating the substrate 8.

Provided at the outer side of the chamber 13 is a magnetic field forming means 33 for forming a magnetic field on the microwave-introducing section 4 side. This magnetic field forming means 33 is constituted as an electromagnet comprised of a ferromagnetic body 31 and a solenoid 34 connected to a direct current source 32.

Operation of the apparatus shown in Fig. 5 will be described below by taking as an example an instance where a silicon substrate is etched.

First, the inside of the chamber 13 was exhausted to about 133 x $10^{-7}$ Pa ($10^{-7}$ Torr) by means of the exhaust pump 70, and thereafter 90 SCCM of CF$_4$ and 10 SCCM of O$_2$ were introduced through the gas-introducing pipe 50 and the ring gas ejector 51. As a result, the pressure in the chamber 13 was kept at 5 x 0,13 Pa (5 x $10^{-3}$ Torr). Then the direct current source 32 was switched on to form a magnetic field of 8,75 x $10^{-2}$ Vsm$^{-2}$ (875 gauss) in a specified zone in the front side of the mesh 40.

Next, the electric source for the microwave oscillator 1 of a frequency of 2.45 GHz was switched on and the three-stub tuner 2 was adjusted while looking at the power monitor 24. As a result, a plasma was generated only at the plasma zone 30. In this occasion, the microwaves were propagated into the chamber 13 with good efficiency by virtue of the constriction 23. The surplus gas was also able to be exhausted by means of the exhaust pump 70 without escape of microwaves to the exhaust system.

After 10 minutes, the substrate was taken out to be found that there was applied etching without damage by plasma. Also, there occurred little rise in the temperature at the microwave-introducing section 4.

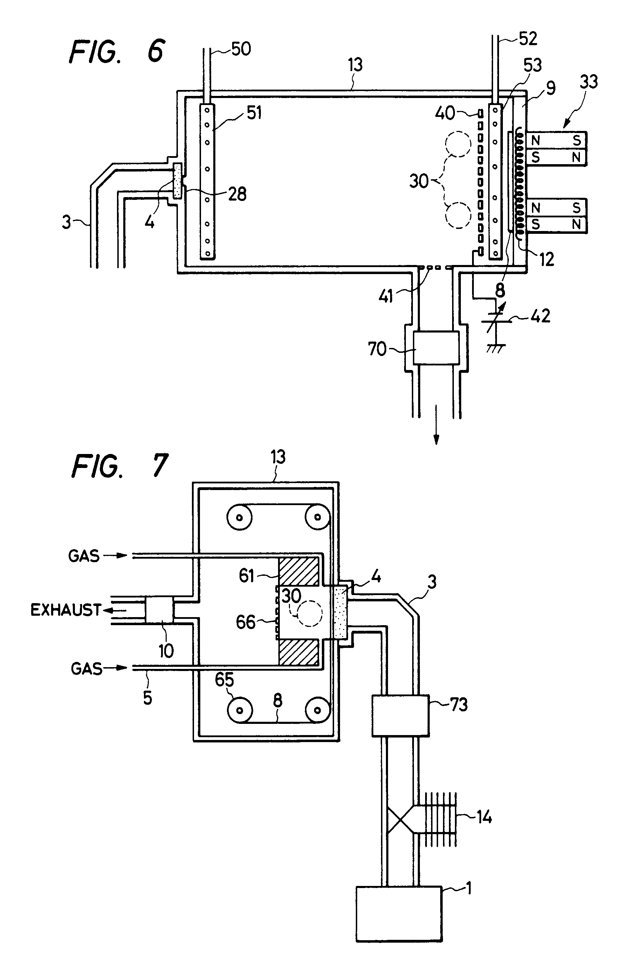

Fig. 6 illustrates still another example of the present invention, wherein a slot antenna 28 is used as the microwave antenna, a ring gas ejector 51 is provided in front of a microwave-introducing section 4 and connected to a gas-introducing pipe 50 and, a ring gas ejector 53 connected to a gas-introducing pipe 52 is also provided between a substrate 8 and a mesh 40. The gas-introducing pipe 50 and the ring gas ejector 51 are provided to supply a non-film-forming gas, and the gas-introducing pipe 52 and the ring gas ejector 53 are provided to supply a film-forming gas.

The non-film-forming gas is meant to be a gas that may not form a film only by itself, and the film-forming gas is meant to be a gas that forms a film by the reaction with an activated and/or other gas. The film deposition to the microwave-introducing section 4 can be surely prevented by separately supplying the non-film-forming gas and the film-forming gas as described above.

The film-forming gas may include, for example, gases of silicon hydrides such as silane, disilane and trisilane, hydrocarbons such as methane, ethane, propane and acetylene, aromatic hydrocarbons such as benzene, toluene and xylene, halogenated hydrocarbons such as tetrafluoromethane, tetrachloromethane, $CH_2F_2$ and $CH_3F$, etc. The non-film-forming gas may include, for example, hydrogen, argon, helium, nitrogen, etc. The film-forming gas may be used as a mixture with the non-film-forming gas.

The mesh 40 is made of a metal, connected to a variable direct current source 42, and constituted such that any desired potential can be applied thereto. The constitution so made as to apply the potential to this mesh 40 makes it possible to surely control the charged particles by the potential.

The magnetic field forming means 33 comprises permanent magnets arranged in alternately reversed directions, and is thereby so constituted that a magnetic field satisfying the ECR conditions can be formed at the front side of the mesh 40.

Operation of the present apparatus will be described below taking as an example an instance where an amorphous silicon film is formed.

First, like the manner previously described, the inside of the chamber 13 was exhausted to about $1,33 \times 10^{-5}$ Pa ($10^{-7}$ Torr) by means of the exhaust pump 70, and thereafter 20 SCCM of $H_2$ and 20 SCCM of $SiH_4$ respectively were introduced through the gas-introducing pipes 50 and 52 and the ring gas ejectors 51 and 53. As a result, the pressure in the chamber 13 was kept at $3 \times 0,13$ Pa ($3 \times 10^{-3}$ Torr). Next, the substrate temperature was raised to 250°C by means of a heater 12, and the mesh 40 was fixed to +30 V to the ground by means of the variable direct current source 42. Then, microwaves with a frequency of 2.45 GHz were propagated to the plasma zone 30 from the slot antenna 28. Thus, the plasma was generated predominantly in the plasma zone 30. After 10 minutes, the substrate was taken out to find that there was formed an amorphous silicon film of 3 $\mu$m thickness, without damage by plasma, and of good quality.

In this way, the mesh 40 may be provided at a site kept apart from the microwave-introducing section 4 and the ECR plasma may be caused to be generated there to obtain the effect that the damage by plasma can be made small and also the deposition of stains to the microwave-introducing section 4 and the temperature rise can be lessened. The charged particles reaching to the substrate 8 can also be readily controlled by changing the potential of the mesh. As for the propagation of microwaves, the employment of the antenna can improve its efficiency, and particularly the employment of the horn antenna made it possible to suppress the reflection of microwaves to 20% or less. It is further possible to prevent the film from being deposited on the microwave-introducing section 4 particularly by causing the non-film-forming gas to eject from the vicinity of the microwave-introducing section 4, and the film-forming gas, from the vicinity of the mesh 40.

As another embodiment of the present invention, described below is an example in which a substrate is set adjacent to the microwave-introducing section, and a plasma generating zone is provided in a space at the substrate surface side opposite to the microwave-introducing surface.

Here, since a substrate that reflects microwaves can not be suited for introducing the microwaves into the reaction chamber, it must be of the type that the microwaves can be transmitted to a certain extent. Further, a substrate exhibiting a large absorption to microwaves and having a low melting point is not suitable as there is a high possibility of being fused at the time of introducing the microwaves.

The absorption of microwaves to the substrate can be approximated by the following equation:

$$P = A \cdot \epsilon_s \cdot \tan\delta \qquad (I)$$

Here, P represents absorption ratio; A, a coefficient that depends on the frequency of microwaves, shape of substrate, strength of microwave electric field, etc.; $\epsilon_s$, a relative dielectric constant; and $\tan\delta$, a dielectric loss tangent. It is seen from Equation (I) that $\epsilon_s \tan\delta$ may preferably be not more than a certain degree. Suitable materials having a small $\epsilon_s \tan\delta$ may include ceramics such as quartz and alumina, Macole (trade name), Teflon (trade name), silicone, polyethylene, polystyrene, polytetrafluoroethylene, white mica, borosilicate glass, etc., but are by no means limited to these. Particularly when even the heating of the substrate is carried out by microwaves, preferred is to select silicone or borosilicate glass having somewhat a large $\epsilon_s \tan\delta$.

The size of the substrate is of a size that the microwave-introducing window is covered, or the size is larger than that.

For efficient generation of plasma by microwaves, effective is to use the electronic cyclotron resonance conditions (ECR conditions) of microwaves and the microwave oscillator. Particularly in the case of the present invention, it sometimes becomes necessary to make the application power of microwaves minimum as it is necessary to protect the substrate. In such an instance, however, it becomes necessary to use the ECR conditions and the oscillator. Here, in order to generate ECR, a magnetic field is required to be formed, for the purpose of which it is possible to use both of the electromagnet and the permanent magnet. As a oscillator, it is possible to use a variety of oscillators such as round oscillators, square oscillators and semi-coaxial type oscillators.

In the instance in which the apparatus of the present invention is used particularly in the film formation, it may occur that the matching of microwaves becomes deviated with deposition of a film on the surface of the substrate. In such a case, it becomes necessary to control the matching with use of an automatching system. For this purpose, there can be contemplated the system such that the incident electric power and refleced electric power of microwaves are detected by use of a directional coupler, and when the matching deviates, a matching adjuster such as the three-stub tuner is finely controlled.

Fig. 7 is a view illustrating an example where an amorphous silicon is formed into a film by utilizing ECR.

In Fig. 7, the numeral 65 denotes rollers to roll up a tape-like substrate 8; 30, an ECR field; and 61, a magnet to generate a magnetic field that causes ECR to occur. Here, polyethylene is used in the substrate denoted as 8.

First, the inside of a reaction chamber 13 was preliminarily exhausted to $1,33 \times 10^{-5}$ Pa ($10^{-7}$ Torr). $H_2$ at 40 SCCM and $SiH_4$ at 20 SCCM were introduced therein from the gas introducing tube 5, and the inner pressure of the reaction chamber was kept at $8 \times 0,13$ Pa ($8 \times 10^{-3}$ Torr). Thereafter microwaves were introduced to the space 30 through an introducing window 4 by means of a microwave oscillator 1. As a result, ECR occurred to generate plasma.

At this time, the microwaves were set to an incident power of 30 W and a reflection power of 10 W, and the incident power and reflection power are kept substantially constant also during the film formation by means of an automatching apparatus 73. During the film formation, the polyethylene was rolled up at a rate of 5 mm per minute. After the film formation, the substrate was taken out to be found that there was formed a film of amorphous silicon of 1 $\mu$m in thickness. Also, there were seen little stains on the microwaves-introducing window 4, and there were seen little stains also on the inner wall of the chamber except for the space 30.

Thus, the introduction of microwaves from the back of the substrate leads to the following advantages:

(1) The stains on the microwave-introducing window or inside the chamber can be minimized at the time of the film formation.

(2) The treatment speed can be increased.

(3) Selection of a particular substrate eliminates the necessity for use of any substrate-heating apparatus.

(4) When uniform treatment is made on a large area, the substrate may be moved at the front of the microwave-introducing window.

## Claims

1. An apparatus for treating a substrate, comprising

   a chamber for encasing the substrate and provided with a microwave introducing section,

   means for generating plasma within said chamber to treat the substrate in the vicinity of the substrate and in a spatial zone sufficiently small as compared with the size of the chamber and

   a mesh provided between the plasma formation zone and the substrate.

2. Apparatus according to claim 1, wherein said plasma is formed by utilizing electron cyclotron resonance of microwaves.

3. Apparatus according to claim 1, wherein said substrate is disposed at a position kept apart from the microwave-introduction section.

4. Apparatus according to any of claims 1 to 3, wherein said means for generating plasma includes means for generating a magnetic field.

5. Apparatus according to any of claims 1 to 4, wherein said mesh is made of metal.

6. Apparatus for treating a substrate, comprising
    a chamber for encasing the substrate and provided with a microwave introducing section,
    means for generating plasma within said chamber to treat the substrate by said plasma, said substrate being microwave transmissive and placed in the vicinity of the microwave introducing section,
    wherein said means for generating plasma is provided to generate plasma in the vicinity of the substrate in a spatial zone sufficiently small as compared with the size of the chamber and at the substrate surface side opposite to the microwave introducing surface.

7. Apparatus according to claim 6, wherein said plasma is formed by utilizing electron cyclotron resonance of microwaves.

8. Apparatus according to claim 6, wherein said means for generating plasma is a means for forming a magnetic field.

**Patentansprüche**

1. Gerät zum Behandeln eines Substrates mit
   einer Kammer, die das Substrat umgibt und mit einem Abschnitt zum Einbringen von Mikrowellen versehen ist,
   einer Plasmaerzeugungsvorrichtung, die zum Behandeln des Substrates in der Nähe des Substrates und in einem Raumbereich, der ausreichend klein im Vergleich zur Größe der Kammer ist, ein Plasma in der Kammer erzeugt, und
   einem Gitter, das sich zwischen der Plasmabildungszone und dem Substrat befindet.

2. Gerät nach Anspruch 1, bei dem das Plasma durch Ausnutzung von Elektronenzyklotronresonanz von Mikrowellen gebildet wird.

3. Gerät nach Anspruch 1, bei dem das Substrat an einer von dem Abschnitt, durch den die Mikrowellen eingebracht werden, getrennten Stelle angeordnet ist.

4. Gerät nach einem der Ansprüche 1 bis 3, bei dem die Plasmaerzeugungsvorrichtung eine Vorrichtung zum Erzeugen eines Magnetfeldes beinhaltet.

5. Gerät nach einem der Ansprüche 1 bis 4, bei dem das Gitter aus Metall gefertigt ist.

6. Gerät zum Behandeln eines Substrates mit
   einer Kammer, die das Substrat umgibt und mit einem Abschnitt zum Einbringen von Mikrowellen versehen ist,
   einer Plasmaerzeugungsvorrichtung, die in der Kammer ein Plasma zum Behandeln des Substrates mit dem Plasma erzeugt, wobei das Substrat für Mikrowellen durchlässig ist und in die Nähe des Abschnittes, durch den die Mikrowellen eingebracht werden, angeordnet ist, wobei die Plasmaerzeugungsvorrichtung dazu vorgesehen ist, in der Nähe des Substrates in einem Raumbereich, der im Vergleich zur Größe der Kammer ausreichend klein ist, und auf der dem Abschnitt, durch den die Mikrowellen eingebracht werden, entgegengesetzten Seite des Substrates Plasma zu erzeugen.

7. Gerät nach Anspruch 6, bei dem das Plasma durch Ausnutzung von Elektronenzyklotronresonanz von Mikrowellen gebildet wird.

8. Gerät nach Anspruch 6, bei dem die Plasmaerzeugungsvorrichtung eine Vorrichtung zur Bildung eines Magnetfeldes ist.

**Revendications**

1. Un appareil pour le traitement d'un substrat, comprenant :
   une chambre destinée à enfermer le substrat et comportant une section d'introduction de micro-ondes,
   des moyens de génération de plasma à l'intérieur de la chambre, pour traiter le substrat, situés au voisinage du substrat et dans une zone spatiale suffisamment petite en comparaison avec la taille de la chambre, et
   un treillis placé entre la zone de formation de plasma et le substrat.

2. Appareil selon la revendication 1, dans lequel le plasma est formé par l'utilisation de la résonance cyclotron d' électrons sous l'effet de micro-ondes.

**3.** Appareil selon la revendication 1, dans lequel le substrat est disposé en une position qui est maintenue éloignée de la section d'introduction de micro-ondes.

**4.** Appareil selon l'une quelconque des revendications 1 à 3, dans lequel les moyens de génération de plasma comprennent des moyens qui sont destinés à générer un champ magnétique.

**5.** Appareil selon l'une quelconque des revendications 1 à 4, dans lequel le treillis est en métal.

**6.** Appareil pour traiter un substrat, comprenant :

une chambre destinée à enfermer le substrat et comportant une section d'introduction de micro-ondes,

des moyens de génération de plasma à l'intérieur de la chambre, pour traiter le substrat au moyen du plasma, ce substrat transmettant les micro-ondes et étant placé au voisinage de la section d'introduction de micro-ondes,

dans lequel les moyens de génération de plasma sont incorporés de façon à générer un plasma au voisinage du substrat, dans une zone spatiale suffisamment petite en comparaison avec la taille de la chambre, et du côté de la surface du substrat qui est opposée à la surface d'introduction des micro-ondes.

**7.** Appareil selon la revendication 6, dans lequel le plasma est formé par l'utilisation de la résonance cyclotron d'électrons sous l'effet de micro-ondes.

**8.** Appareil selon la revendication 6, dans lequel les moyens de génération de plasma sont constitués par des moyens destinés à produire un champ magnétique.

*FIG. 1*

*FIG. 2*

10

FIG. 3

FIG. 4

FIG. 5

GAS SUPPY

EXHAUST

FIG. 6

FIG. 7

GAS

EXHAUST

GAS

FIG. 8-1

FIG. 8-2

FIG. 8-3

FIG. 8-4

FIG. 8-5

FIG. 8-6

FIG. 8-7

FIG. 8-8

13